Europäisches Patentamt

European Patent Office

Office européen des brevets

(19)

(11) EP 0 896 435 A2

(12) **EUROPÄISCHE PATENTANMELDUNG**

(43) Veröffentlichungstag:
10.02.1999 Patentblatt 1999/06

(51) Int. Cl.⁶: $H03M\ 1/50$

(21) Anmeldenummer: 98114016.3

(22) Anmeldetag: 27.07.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 07.08.1997 DE 19734222

(71) Anmelder:
Siemens Audiologische Technik GmbH
91058 Erlangen (DE)

(72) Erfinder:
• Pfannenmüller, Gerhard Dipl.-Ing.
90522 Oberasbach (DE)
• Sigwanz, Ullrich Dipl.-Inf.
91353 Hausen (DE)

(74) Vertreter:
Epping, Wilhelm, Dr.-Ing. et al
Patentanwalt
Postfach 22 13 17
80503 München (DE)

(54) **Schaltung und Verfahren zur Digitalwandlung einer analogen Stellgrösse in einem digitalen Hörgerät**

(57) Die Erfindung betrifft eine Schaltung zur Digitalwandlung einer analogen Stellgröße in einem Hörgerät mit digitaler Signalverarbeitung mit mindestens einem Vergleichselement, an dem ein Rampensignal und die analoge Stellgröße anliegen, wobei die Umschaltschwelle des Vergleichselements durch den Betrag der analogen Stellgröße bestimmt wird sowie mindestens einem dem Vergleichselement nachgeschalteten digitalen Tiefpaßfilter.

FIG 1

EP 0 896 435 A2

**Beschreibung**

Die Erfindung betrifft eine Schaltung zur Digitalwandlung einer analogen Stellgröße in einem Hörgerät mit digitaler Signalverarbeitung. Ferner betrifft die Erfindung ein Verfahren zur Anwendung mit einer derartigen Schaltung nach dem Oberbegriff des Patentanspruchs 13.

Üblicherweise werden analoge Stellgrößen durch Verwendung aufwendiger Analog-/Digitalwandler in digitale Größen zur weiteren Signalverarbeitung umgewandelt.

Der Erfindung liegt die Aufgabe zugrunde, eine Schaltung sowie ein Verfahren zur Digitalwandlung einer analogen Stellgröße anzubieten, bei dem kein Analog-/Digitalwandler benötigt wird.

Die Aufgabe wird durch die Schaltung nach Patentanspruch 1 gelöst. Vorteilhafte Ausführungsformen der Schaltung werden in den Unteransprüche 2 - 12 beschrieben. Hinsichtlich des Verfahrens wird die Aufgabe durch den kennzeichnenden Teil des Patentanspruchs 13 gelöst. Vorteilhafte Verfahrensvarianten werden durch die Unteransprüche 14 - 17 realisiert.

Die erfindungsgemäße Schaltung benötigt zur Digitalwandlung einer analogen Stellgröße lediglich ein Vergleichselement, an dem ein Rampensignal sowie die analoge Stellgröße anliegen sowie einen nachgeschalteten Tiefpaßfilter. Durch die am Vergleichselement anliegende analoge Stellgröße wird die Umschaltschwelle des Vergleichselements entsprechend eingestellt, so daß als Ausgangssignal des Vergleichselements ein Rechtecksignal entsteht, dessen Signaldauer abhängig von der jeweils am Vergleichselement über die analoge Stellgröße eingestellten Umschaltschwelle ist.

Das Rampeneingangssignal des Vergleichselements wird somit pulsweitenmoduliert (PMW, pulswidth-modulation). Dieses pulsweitenmodulierte Signal tritt nun in einen digitalen Tiefpaßfilter ein, wodurch eine Mittelwertbildung und eine Beseitigung von Signalfehlern (insbesondere von „Jitter-Fehlern") stattfindet.

Als Ausgangssignal des digitalen Tiefpaßfilters entsteht eine digitale Stellgröße, deren Betrag mit der Dauer des jeweiligen verarbeiteten Rechteckimpulses des pulsweitenmodulierten Signals korrespondiert.

Vorteilhafterweise wird zur Erzeugung des am Vergleichselement anliegenden Rampensignals eine Oszillatoreinrichtung verwendet, und zwar je nach gewünschtem Schaltungsaufwand und Variabilität, z.B. ein RC-Glied, ein Integrator oder ein Treppenspannungsgenerator.

Zur Erzeugung der analogen Stellgröße kann bei digitalen/digital einstellbaren Hörgeräten ein vom Benutzer verstellbares Potentiometer verwendet werden. Dessen analoge Stellgröße kann durch die erfindungsgemäße Schaltung mit geringem Schaltungsaufwand in eine digitale Stellgröße überführt werden.

Vorteilhafterweise wird zur Ansteuerung der Oszillatoreinrichtung und/oder des digitalen Tiefpaßfilters ein einziges Taktelement verwendet, das zur Vermeidung von Frequenzmischungen zwischen der Oszillatoreinrichtung und dem digitalen Schaltungsbereich sich vorzugsweise im digitalen Schaltungsbereich befindet.

Als Vergleichselement kann ein Komparator oder ein als Komparator geschalteter Operationsverstärker verwendet werden.

Zur Überführung der jeweiligen Amplitude des Ausgangssignals des Vergleichselements in kompatible „1"-Amplituden bzw. „0"-Amplituden zur Einleitung in den digitalen Tiefpaßfilter wird vorzugsweise eine Multiplexeinheit verwendet, die sich zwischen dem Vergleichselement und dem digitalen Tiefpaßfilter befindet.

In einer vorteilhaften Ausführungsform der erfindungsgemäßen Schaltung sind ein einziges Taktelement und eine einzige Oszillatoreinrichtung vorgesehen, welche eine Reihe von Gesamteinheiten voneinander zugeordneten Vergleichselementen, digitalen Tiefpaßfiltern und gegebenenfalls jeweiliger zwischengeschalteter Multiplexeinheiten ansteuern. Hierdurch können durch ein einziges Taktelement und eine einzigen Oszillatoreinrichtung eine Vielzahl von Gesamteinheiten versorgt werden.

Vorteilhafterweise durchläuft die digitale Stellgröße als Ausgangssignal des digitalen Tiefpaßfilters eine weitere Verarbeitungseinheit mit eingebbaren Kennlinien. Auf diesem Wege können im Analogbereich der Schaltung die eingesetzten Stellglieder zur Erzeugung der analogen Stellgröße (z.B. Potentiometer) sämtlich baugleich ausgeführt werden, um die erforderlichen Unterschiede bei der Signalverarbeitung durch Nachbearbeitungen der digitalen Stellgröße in den Verarbeitungseinheiten vorzunehmen.

Eine zuverlässige (Jitter-)Fehlerbeseitigung des pulsweitenmodulierten Signals beim Durchlauf des digitalen Tiefpaßfilters tritt insbesondere bei einer größeren Zeitkonstante des Tiefpaßfilters auf. Eine besonders vorteilhafte Schaltung ergibt sich bei Tiefpaßfiltern erster Ordnung.

Um sowohl eine angemessene Fehlerbeseitigung als auch eine ausreichende Bearbeitungszeit zu erzielen, kann es vorteilhaft sein, auch oder nur digitale Tiefpaßfilter höherer Ordnung, insbesondere 2. -4. Ordnung, zu verwenden.

Bei Verwendung mehrerer digitaler Tiefpaßfilter innerhalb der Schaltung können auch abhängig von den jeweiligen Programmierungswünschen digitale Tiefpaßfilter unterschiedlicher Ordnungen verwendet werden.

Zur zuverlässigen Fehlerbeseitigung des pulsweitenmodulierten Signals sollte der digitale Tiefpaßfilter eine Zeitkonstante von mindestens 1 sec aufweisen.

Für eine individuelle Signalverarbeitung besitzt der digitale Tiefpaßfilter vorteilhafterweise veränderliche Einstellparameter, um eine Einstellung, z.B. der Länge des Datenworts, Arbeitsfrequenz, der fiktiven Lade-/Entladekonstante etc., zu ermöglichen.

Beim erfindungsgemäßen Verfahren zur Digitalwandlung einer anlogen Stellgröße in einem Hörgerät mit digitaler Signalverarbeitung/digitalen Stellgrößen findet zunächst eine Pulsweitenmodulation (PWM,pulse-width-modulation) des Signals der analogen Stellgröße statt. Das pulsweitenmodulierte Signal wird dann durch Mittelwertbildung und/oder Beseitigung von Signalfehlern (insbesondere „Jitter-Fehlern") in eine digitale Stellgröße überführt. Einige Einzelheiten des erfindungsgemäßen Verfahrens wurden bereits, in Verbindung mit der Erläuterung der erfindungsgemäßen Schaltung beschrieben.

In einer vorteilhaften Verfahrensvariante findet vor der Mittelwertbildung und/oder Entfernung von Signalfehlern eine Zuordnung eines Signalwertes („0" oder „1") zu dem pulsweitenmodulierten Signal für eine weitere digitale Signalverarbeitung statt.

Das erfindungsgemäße Verfahren ermittelt eine digitale Stellgröße, deren Betrag mit der Dauer eines Rechteckimpulses des pulsweitenmodulierten Signals korrespondiert. Hierdurch kann der entstehenden digitalen Stellgröße genau eine einzige analoge Stellgröße zugeordnet werden.

Durch eine Bearbeitung der ermittelten digitalen Stellgröße nach vorgebbaren Kennlinienverläufen kann der Schwerpunkt der Stellgrößenverarbeitung in den digitalen Bereich gelegt werden, so daß im analogen Bereich weitgehend standardisierte und baugleiche Stellglieder (z.B. Potentiometer) eingesetzt werden können.

Bei der Mittelwertbildung des pulsweitenmodulierten Signals wird vorteilhafterweise auf die Formel nach Anspruch 16 zurückgegriffen. Der dortige Zeitparameter c dient zur Einstellung des Zeitverhaltens des digitalen Tiefpaßfilter und kann durch Verstellung an die jeweiligen Anforderungen der Fehlerfreiheit bzw. Überarbeitungszeit angepaßt werden.

Die Schaltung sowie das Verfahren sind anhand von Ausführungsbeispielen in den Zeichnungsfiguren näher erläutert. Es zeigen:

FIG 1     ein Schaltbild der erfindungsgemäßen Schaltung sowie

FIG 2     ein Beispiel für eine verfahrensgemäße Mittelwertbildung.

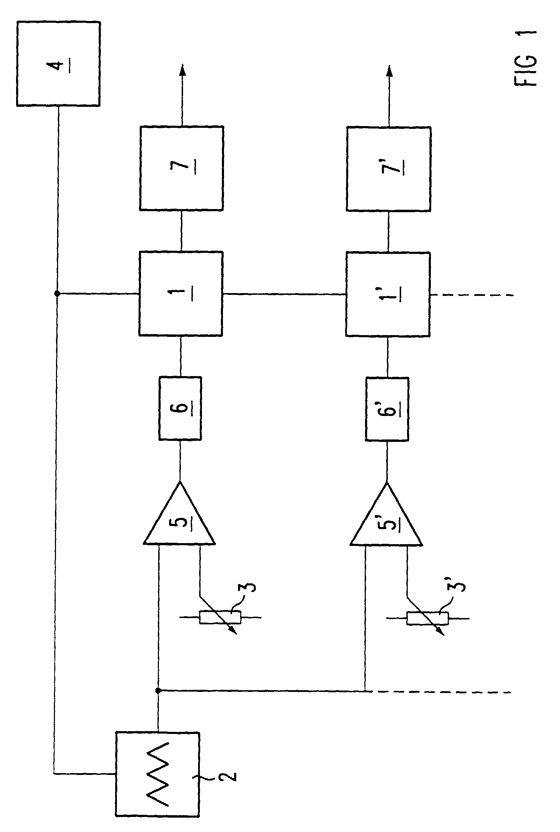

FIG 1 weist zunächst einen Komparator 5 auf, an dessen Eingängen eine Oszillatoreinrichtung 2 mit einem Rampensignal sowie ein Potentiometer 3 befinden. Über den Potentiometer 3 wird die Umschaltschwelle des Komparators 5 eingestellt, so daß als Ausgangssignal des Komparators 5 Rechteckimpulse mit variabler Impulsdauer (in Abhängigkeit von der über den Potentiometer 3 eingestellten analogen Stellgröße) entstehen. Dieses Ausgangssignal des Komparators 5 kann nun direkt in den digitalen Tiefpaßfilter 1 eingeleitet werden (nicht abgebildet).

Nach FIG 1 wird das Ausgangssignal des Komparators 5 über die Multiplexeinheit 6 geführt, wodurch dem pulsweitenmodulierten Ausgangssignal des Komparators 5 die Werte „1" (bei vorliegendem und andauerndem Rechteckimpuls) bzw. „0" (wenn kein Rechteckimpuls vorliegt) zugeordnet werden. Somit kann eine „Normierung" des pulsweitenmodulierten Ausgangssignals des Komparators 5 erfolgen.

Im digitalen Tiefpaßfilter 1 erfährt das pulsweitenmodulierte Ausgangssignal des Komparators 5 eine Mittelwertbildung sowie eine Beseitigung von Signalfehlern, insbesondere von „Jitter-Fehlern". Mit zunehmender Zeitkonstante t des digitalen Tiefpaßfilters 1 erfolgt eine besonders gute Fehlerbeseitigung.

Als Ausgangssignals des digitalen Tiefpaßfilters 1 entsteht eine digitale Stellgröße, deren Betrag mit der Dauer des Rechteckimpulses des jeweiligen verarbeiteten pulsweitenmodulierten Ausgangssignals des Komparators 5 korrespondiert. Somit ist den analogen Stellgrößen das Potentiometers 3 genau eine digitale Stellgröße als Ausgangssignal des digitalen Tiefpaßfilters 1 zugeordnet.

Die entstehende digitale Stellgröße wird schließlich noch durch die Verarbeitungseinheit 7 hindurchgeführt und einstellbaren Kennlinienverläufen unterworfen. Somit kann auch durch Verwendung weitgehend baugleicher und einfacher Bauteile auf der Analogseite (z.B. identischer Potentiometer 3) durch eine entsprechende Bearbeitung der digitalen Stellgröße in Verarbeitungseinheiten 7 eine Realisierung gewünschter Kennlinienverläufe erreicht werden.

Die Schaltung nach FIG 1 kann unter Verwendung eines einzigen Taktelementes 4 zur Ansteuerung einer einzigen Oszillatoreinrichtung 2 aus einer Vielzahl weiterer Komparatoren 5', Multiplexeinheiten 6' und digitaler Tiefpaßfilter 1' bestehen, ohne daß mehrere Oszillatoreinrichtungen 2 oder Taktelemente 4 eingesetzt werden müssen.

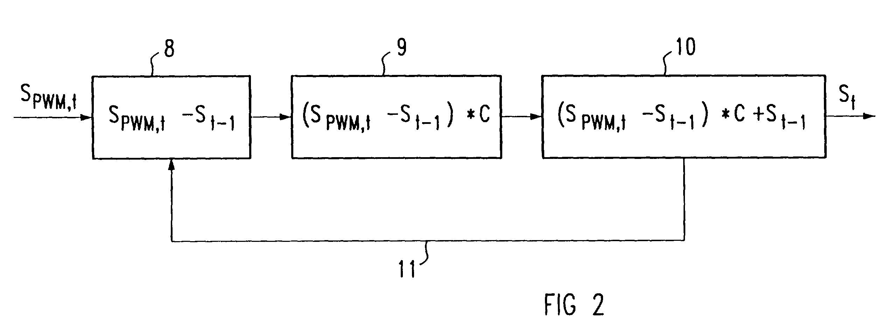

Aus FIG 2 geht die im digitalen Tiefpaßfilter 1 stattfindende Mittelwertbildung nach der Formel

$$S_t = (S_{PWM,t} - S_{t-1}) \times c + S_{t-1}$$

hervor.

Zunächst tritt das pulsweitenmodulierten Signal $S_{PWM,t}$ zum Zeitpunkt t in die Differenzeinheit 8 ein. Hier findet die Differenzbildung $S_{PWM,t} - S_{t-1}$ statt. $S_{t-1}$ stellt die digitale Stellgröße dar, die zum Zeitpunkt t-1 im digitalen Tiefpaßfilter 1 ermittelt und abgespeichert wurde.

Die in der Differenzeinheit 8 entstehende Differenz wird nunmehr mit dem Zeitparameter c in der Multiplikationseinheit 9 multipliziert. Daraufhin folgt eine Addition mit der digitalen Stellgröße $S_{t-1}$ in der Additionseinheit 10 und es entsteht der Wert für die digitale Stellgröße zum Zeitpunkt t, also $S_t$.

Dieser Wert $S_t$ wird über die Speicherverbin-

dung 11 auch in der Differenzeinheit 8 abgespeichert, um bei der Mittelwertbildung des nächstfolgenden Wertes $S_{PWM,t+1}$ verwendet zu werden.

Der Zeitparameter c, der innerhalb der Multiplikationseinheit 9 als Multiplikator dient, ist vorteilhafterweise innerhalb des digitalen Tiefpaßfilters 1 veränderbar, so daß in Abhängigkeit von den Anforderungen an die Fehlerbeseitigung sowie die Verarbeitungszeit eine entsprechende Einstellung vorgenommen werden kann.

## Patentansprüche

1. Schaltung zur Digitalwandlung einer analogen Stellgröße in einem Hörgerät mit digitaler Signalverarbeitung mit

   - mindestens einem Vergleichselement, an dem ein Rampensignal und die analoge Stellgröße anliegen, wobei die Umschaltschwelle des Vergleichselements durch den Betrag der analogen Stellgröße bestimmt wird sowie

   - mindestens einem dem Vergleichselement nachgeschalteten digitalen Tiefpaßfilter (1) zur Ermittlung einer digitalen Stellgröße durch zeitliche Mitelung des Ausgangssignals des Vergleichselements.

2. Schaltung nach Anspruch 1,
   dadurch gekennzeichnet, daß eine Oszillatoreinrichtung (2), insbesondere ein RC-Glied oder ein Integrator oder ein Treppenspannungsgenerator zur Erzeugung des Rampensignals dienen.

3. Schaltung nach Anspruch 1 oder 2,
   dadurch gekennzeichnet, daß die analoge Stellgröße das Ausgangssignal eines Potentiometers (3) darstellt.

4. Schaltung nach einem der Ansprüche 1 - 3,
   dadurch gekennzeichnet, daß ein Taktelement (4) zur Ansteuerung der Oszillatoreinrichtung (2) und/oder des digitalen Tiefpaßfilters (1) dient.

5. Schaltung nach einem der Ansprüche 1 - 4,
   dadurch gekennzeichnet, daß als Vergleichselement ein Komparator (5) dient.

6. Schaltung nach einem der Ansprüche 1 - 5,
   dadurch gekennzeichnet, daß zwischen dem Vergleichselement und dem digitalen Tiefpaßfilter (1) eine Multiplexeinheit (6) vorgesehen ist.

7. Schaltung nach einem der Ansprüche 1 - 6,
   dadurch gekennzeichnet, daß ein Taktelement (4) und eine Oszillatoreinrichtung (2) sowie mehrere Gesamtheiten einander zugeordneter Vergleichselemente, digitaler Tiefpaßfilter (1) und Multiplexeinheiten (6) vorgesehen sind.

8. Schaltung nach einem der Ansprüche 1 - 7,
   dadurch gekennzeichnet, daß mindestens eine Verarbeitungseinheit (7) zur Bearbeitung des Ausgangssignals des digitalen Tiefpaßfilters (1) vorgesehen sind.

9. Schaltung nach einem der Ansprüche 1 - 8,
   dadurch gekennzeichnet, daß mindestens ein digitaler Tiefpaßfilter (1) erster Ordnung verwendet wird.

10. Schaltung nach einem der Ansprüche 1- 9,
    dadurch gekennzeichnet, daß mindestens ein digitaler Tiefpaßfilter (1) höherer Ordnung, insbesondere zweiter bis vierter Ordnung verwendet wird.

11. Schaltung nach einem der Ansprüche 1 - 10,
    dadurch gekennzeichnet, daß der digitale Tiefpaßfilter (1) eine Zeitkonstante von mindestens 1 sec aufweist.

12. Schaltung nach einem der Ansprüche 1 - 11,
    dadurch gekennzeichnet, daß der digitale Tiefpaßfilter (1) in seinen Einstellparametern (z.B. Länge des Datenworts, Arbeitsfrequenz, fiktive Lade-/Entladekonstante) veränderbar ist.

13. Verfahren zur Digitalwandlung einer analogen Stellgröße in einem Hörgerät mit digitaler Signalverarbeitung, insbesondere unter Verwendung einer Schaltung nach einem der Ansprüche 1 - 12,
    dadurch gekennzeichnet, daß

    - eine Pulsweitenmodulation (PWM,pulse-width-modulation) des Signals der analogen Stellgröße erfolgt,

    - dem pulsweitenmodulierten Signal ein Signalwert („0" oder „1") zugeordnet wird sowie

    - das mit dem Signalwert versehene pulsweitenmodulierte Signal durch Mittelwertbildung in eine digitale Stellgröße überführt wird.

14. Verfahren nach Anspruch 13,
    dadurch gekennzeichnet, daß der Wert der digitalen Stellgröße mit der Dauer des Rechteckimpulses des jeweiligen pulsweitenmodulierten Signals korrespondiert.

15. Verfahren nach einem der Ansprüche 13 oder 14,
    dadurch gekennzeichnet, daß eine Bearbeitung der digitalen Stellgröße nach vorgebbaren Kennlinienverläufen erfolgt.

16. Verfahren nach einem der Ansprüche 13 - 15, **dadurch gekennzeichnet,** daß die für den Zeitpunkt t Mittelwertbildung und Ermittlung der digitalen Stellgröße St in einem digitalen Tiefpaßfilter (1) ausgehend vom pulsweitenmodulierten Signal $S_{PWM,t}$ für den Zeitpunkt t und eines Zeitparameters c nach folgender Formel erfolgt:

$$S_t = (S_{PWM,t} - S_{t-1}) \times c + S_{t-1}.$$

17. Verfahren nach Anspruch 16, **dadurch gekennzeichnet,** daß der Zeitparameter c des digitalen Tiefpaßfilters (1) einstellbar ist.

FIG 1

$$S_{PWM,t} \rightarrow \boxed{S_{PWM,t} - S_{t-1}}^{\,8} \rightarrow \boxed{(S_{PWM,t} - S_{t-1}) * c}^{\,9} \rightarrow \boxed{(S_{PWM,t} - S_{t-1}) * c + S_{t-1}}^{\,10} \rightarrow S_t$$

FIG 2

EP 0 896 435 A2